# EUROPEAN PATENT APPLICATION

(11) **EP 3 258 110 A1**
(43) Date of publication of application: **20.12.2017**
(21) Application number: 16749011.9
(22) Date of filing: 25.01.2016
(51) Int. Cl.: F04B 41/00, F04B 41/06, H05K 7/20

(54) **PACKAGE-TYPE FLUID MACHINE**

(30) Priority: 09.02.2015 JP 2015023387
(71) Applicant: Anest Iwata Corporation, Yokohama-shi, Kanagawa 223-8501 (JP)
(72) Inventor: SATO, Toru, Yokohama-shi Kanagawa 223-8501 (JP); AIKAWA, Atsushi, Yokohama-shi Kanagawa 223-8501 (JP)
(74) Representative: Vossius & Partner Patentanwälte Rechtsanwälte mbB
(86) International application number: PCT/JP2016/051991
(87) International publication number: WO 2016/129366

(57) **Abstract**

A package type fluid machine includes at least one intake port which is provided in a housing and communicates with an installation region of a plurality of fluid machine units; a plurality of exhaust paths which is provided inside the housing, and includes a first exhaust path which allows gas passed through the fluid machine of the plurality of fluid machine units to flow, and a second exhaust path different from the first exhaust path; and a single exhaust port which is provided in the housing, communicates with downstream end portions of the plurality of exhaust paths, and collects and discharges the gas flowed through the plurality of exhaust paths.

## Description

### Technical Field

The present disclosure relates to a package type fluid machine including a fluid machine unit installed in a housing.

### Background Art

As described in Patent Document 1, there is known a package type fluid machine in which a plurality of compressor units is stacked and the compressor units are housed in a housing. In this machine, a pulley is provided for each of a compressor main body and a motor, and power of the motor is transmitted to the compressor main body by a belt which connects the pulleys. A sirocco fan is built in the compressor main body. Ventilating air is sucked by the sirocco fan, and the compressor main body is cooled.

In the apparatus described in Patent Document 1, a pair of stacking units is disposed to face each other on the right and left sides. The compressor main body of one unit and the motor of the other unit are disposed to face each other, and an intake port is provided in a portion of the housing facing the motor. Furthermore, a main exhaust port is provided above the pair of stacking units disposed to face each other. Meanwhile, cooling air passing through the motor, the compressor main body and an after-cooler in this order is collected in the exhaust duct. A main exhaust port and an exhaust duct exhaust port are separately provided on a top plate of the housing.

### Citation List

### Patent Literature

Patent Document 1: Japanese Unexamined Patent Publication No. 2014-211119

### Summary of Invention

### Technical Problem

For example, when a package type fluid machine is installed in a room, it is necessary to perform ventilation in order to suppress the temperature rise in the room. For example, in a small compressor, it is possible to ventilate the entire room with a relatively small ventilation fan. Meanwhile, in a medium-sized or large-sized compressor, a large-sized ventilation fan is required to ventilate the entire room. Therefore, a method is considered in which a duct is provided in the vicinity of the exhaust port of the package type fluid machine and a ventilation fan is provided in the duct to discharge the gas inside the housing to the outside of the room.

When a plurality of exhaust ports is scattered on the top plate (a ceiling portion) of the housing as in the aforementioned conventional package type fluid machine, since it is necessary to prepare a duct that covers the entire ceiling portion, the size of the duct increases. In addition, since sound generated from the compressor tends to leak from the intake port or the exhaust port, the sound inside the housing leaks to the outside, which may cause a noise.

The present disclosure describes a package type fluid machine capable of reducing the size of the duct that can be mounted for exhaust and also reducing noise.

### Solution to Problem

An aspect of the present invention is a package type fluid machine including a plurality of fluid machine units installed in a housing, the machine including: at least one intake port which is provided in the housing and communicates with an installation region of the plurality of fluid machine units to allow a cooling gas to flow therein; a plurality of exhaust paths which is provided inside the housing, and includes a first exhaust path which allows gas passed through the fluid machine of the plurality of fluid machine units to flow, and a second exhaust path different from the first exhaust path; and a single exhaust port which is provided in the housing, communicates with downstream end portions of the plurality of exhaust paths, and collects and discharges the gas flowed through the plurality of exhaust paths.

According to the package type fluid machine, the cooling gas flowing into the housing from the intake port passes through the fluid machine of the plurality of compressor units and circulates through the first exhaust path. Further, the other part of the gas circulates through the second exhaust path different from the first exhaust path. Further, the gas circulating through the plurality of exhaust paths including the first exhaust path and the second exhaust path is collected and discharged to the outside of the housing from the single exhaust port. In this way, since the exhaust ports are collectively provided, the exhaust ports are not scattered. Therefore, for example, even when a package type fluid machine is installed in a room and a duct is provided in the vicinity of the exhaust port, the duct can be reduced in size. Further, since sound generated by the compressor main body or the like is suppressed from leaking from the exhaust port, it is possible to reduce noise.

The housing may have a plurality of side plate portions and a single top plate portion, and the exhaust port may be provided on the top plate portion. In this case, the exhaust ports are collectively provided on the top plate portion. Therefore, it is possible to reduce the size of the duct which can be provided in the vicinity of the top plate portion.

The package type fluid machine may further include a first stacking unit and a second stacking unit in which the fluid machine units are stacked in each of a first installation region and a second installation region respectively, the first installation region and the second installation region being adjacent to each other in a horizontal direction within the housing, the top plate portion may cover the first stacking unit and the second stacking unit from above, and the exhaust port of the top plate portion may be provided above an intermediate position between the first stacking unit and the second stacking unit. In this case, the distance from the first installation region to the exhaust port and the distance from the second installation region to the exhaust port can be made to be substantially equal to each other. Therefore, gas from the first stacking unit and gas from the second stacking unit can be discharged from the exhaust port in a well-balanced manner.

### Effects of Invention

According to some aspects of the present invention, it is possible to reduce the size of the duct that can be attached for exhaust and furthermore, it is possible to reduce noise.

### Brief Description of Drawings

FIG 1 is a perspective view illustrating a package type fluid machine according to an embodiment of the present invention.
FIG. 2 is a perspective view of the package type fluid machine of FIG. 1 as viewed from the rear side.
FIG. 3 is a plane sectional view illustrating an inflow path of cooling gas.
FIG 4 is a perspective view illustrating first and second stacking units.
FIG. 5(a) is a cross-sectional view illustrating an exhaust path in the first stacking unit, and FIG 5(b) is a cross-sectional view illustrating an exhaust path in the second stacking unit.
FIG. 6 is a perspective view illustrating a flow of a gas at downstream end portions of a plurality of exhaust paths.

### Description of Embodiments

Hereinafter, embodiments of the present invention will be described with reference to the drawings. In the following embodiments, a package type fluid machine having a plurality of compressor units will be described, but the present invention is also applicable to a machine other than the compressor. For example, as the fluid machine, a pump such as a vacuum pump or the like may be used or a blower or the like may be used. In these cases, a motor can be used as a driving source, but a driving source other than the motor may be used. Further, as a fluid machine, an expander or the like may be used. A generator may be connected to the expander.

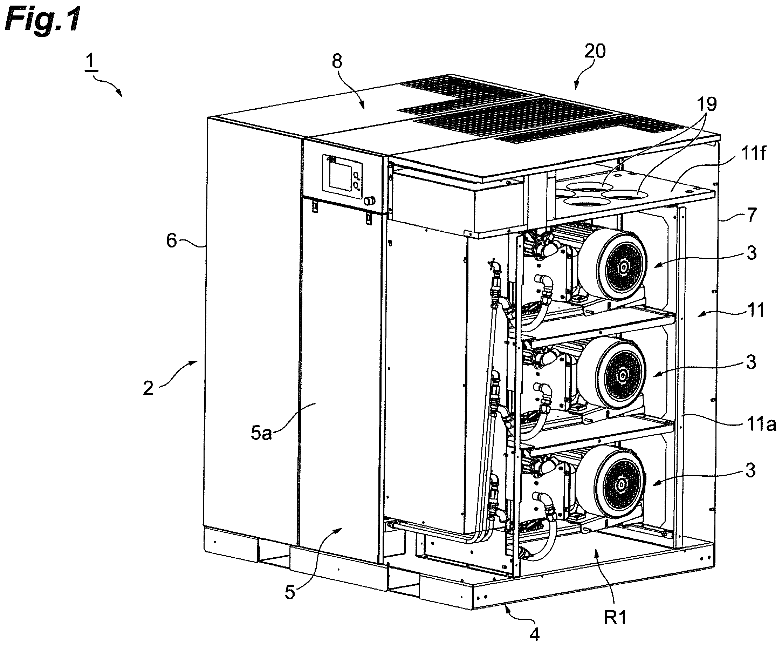

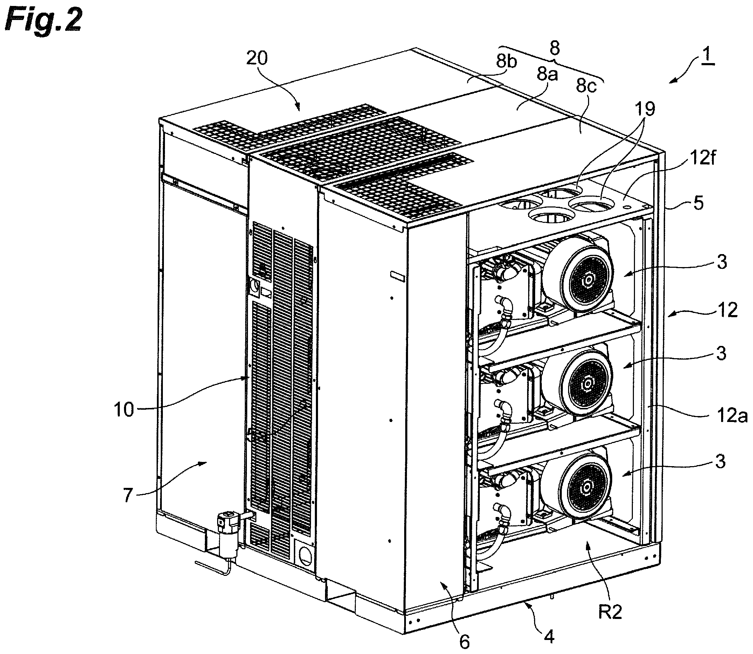

FIGS. 1 and 2 are perspective views illustrating a package type fluid machine 1 according to this embodiment. As illustrated in FIGS. 1 and 2, the package type fluid machine 1 includes a plurality of compressor units (fluid machine units) 3 installed in a housing 2. The package type fluid machine 1 includes, for example, six compressor units 3. The housing 2 is made of, for example, a steel plate. The housing 2 having a rectangular parallelepiped shape has a frame 4 serving as a base of the package type fluid machine 1, a front plate (side plate portion) 5, a pair of side plates (side plate portion) 6, and a rear plate (side plate portion) 7.

At the center of the front plate 5 in a width direction, a vertically elongated inspection door 5a is provided. The front plate 5, the side plate 6, and the rear plate 7 may be made of separate plate members, or the plates may be integrally formed. For example, the corner portions may be integrated. The housing 2 includes a top plate (top plate portion) 8 which closes the openings of the upper surfaces of the front plate 5, the side plate 6 and the rear plate 7. In this way, the housing 2 has a plurality of side plate portions and one top plate portion. In the package type fluid machine 1, one vertically elongated intake port 10 for introducing cooling air (gas) is provided at the center of the rear plate 7 in the width direction (see FIG. 2).

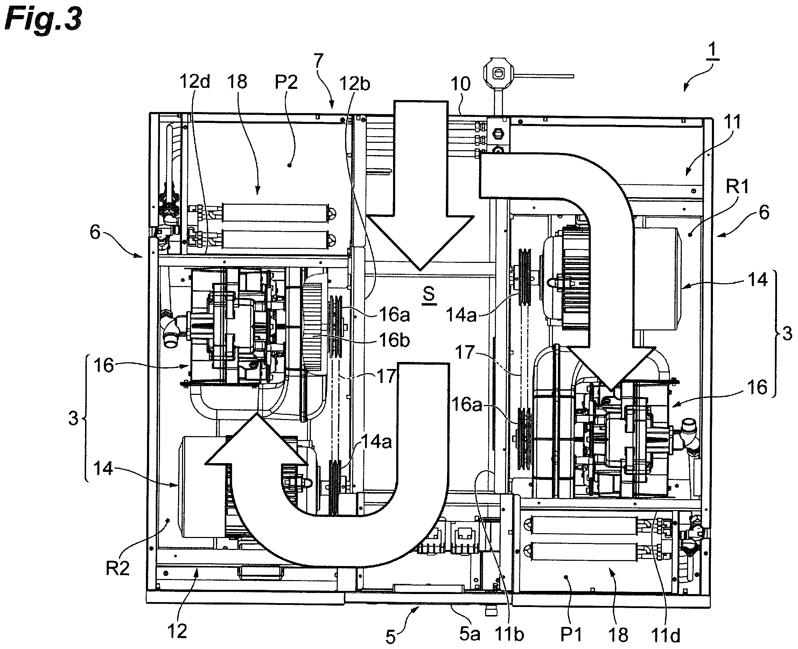

As illustrated in FIG. 3, the compressor unit 3 includes a motor 14 serving as a driving source, and a compressor main body 16 serving as a fluid machine. A belt 17 is laid between a pulley 14a provided in the motor 14 and a pulley 16a provided in the compressor main body 16. The compressor main body 16 is, for example, a scroll type compressor. The motor 14 and the compressor main body 16 are disposed to be lined up in a front-rear direction. In this case, the belt 17 is laid along the front-rear direction.

As illustrated in FIGS. 1 and 2, the package type fluid machine 1 includes a first stacking unit 11 including a plurality of (for example, three) compressor units 3, and a second stacking unit 12 including the compressor units 3 having the same number (for example, three) as the first stacking unit 11. Hereinafter, the first stacking unit 11 and the second stacking unit 12 are abbreviated as a stacking unit 11 and a stacking unit 12. The stacking unit 11 is stacked in an installation region (first installation region) R1 close to one side plate 6. The stacking unit 12 is stacked in an installation region (second installation region) R2 close to the other side plate 6. The installation region R1 and the installation region R2 are adjacent to each other in the left-right direction (a direction in which the side plates 6 face each other, that is, a horizontal direction orthogonal to the front-rear direction). The stacking unit 11 has a rack 11a of a three-stage configuration for installing the three compressor units 3. The stacking unit 12 has a rack 12a of a three-stage configuration for installing the three compressor units 3.

The rack 11 a and the rack 12a are fixed on the frame 4. A compressor unit 3 including a motor 14 and a compressor main body 16 is fixed on each stage of the rack 11 a and the rack 12a. The stacking unit 11 and the stacking unit 12 are disposed side by side to be spaced apart from each other in the left-right direction (see FIG 3). More specifically, the compressor unit 3 in each stage of the stacking unit 11 and the compressor unit 3 in each stage of the stacking unit 12 are provided at the same height, and face each other in the left-right direction. In the stacking unit 11 and the stacking unit 12, the compressor units 3 are disposed to face each other so that the belt 17 of the compressor unit 3 is disposed on the inner side. The compressor main body 16 of the stacking unit 12 faces the motor 14 of the stacking unit 11, and the motor 14 of the stacking unit 12 faces the compressor main body 16 of the stacking unit 11.

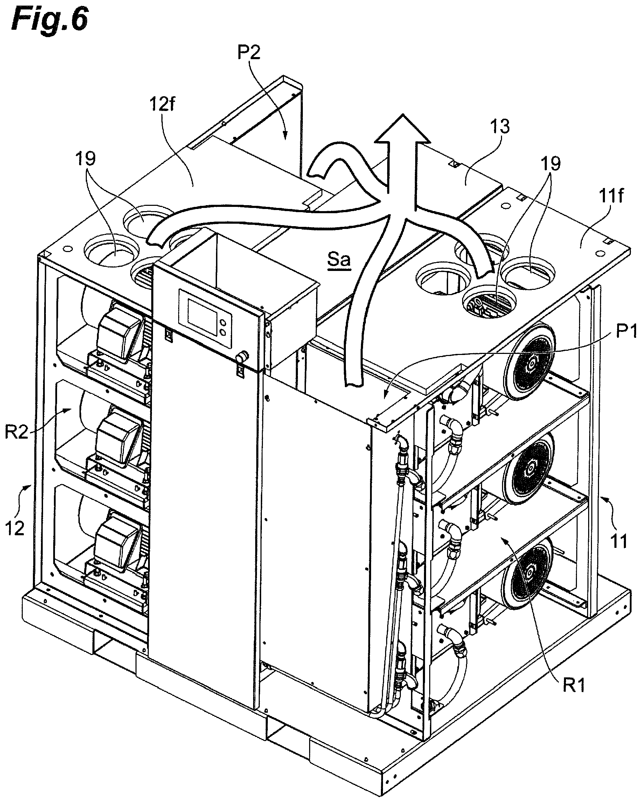

As illustrated in FIG 3, between the stacking unit 11 and the stacking unit 12, that is, between the installation region R1 and the installation region R2, a central space S extending in the front-rear direction and the up-down direction is formed. A partition wall 13 (see FIG. 6) extending along the horizontal plane is provided above the central space S at a position equal to the upper ends of the installation regions R1 and R2. The central space S is a space that can be used at the time of maintenance of the pulley 14a, the pulley 16a, the belt 17, or the like. The central space S communicates with the intake port 10 of the rear plate 7, and functions as an inflow path of the cooling air at the time of the use of the package type fluid machine 1. That is, the rear plate 7 covers the stacking unit 11 and the stacking unit 12 adjacent to each other from rear, and at the intermediate positions thereof, the intake port 10 communicating with the central space S is provided.

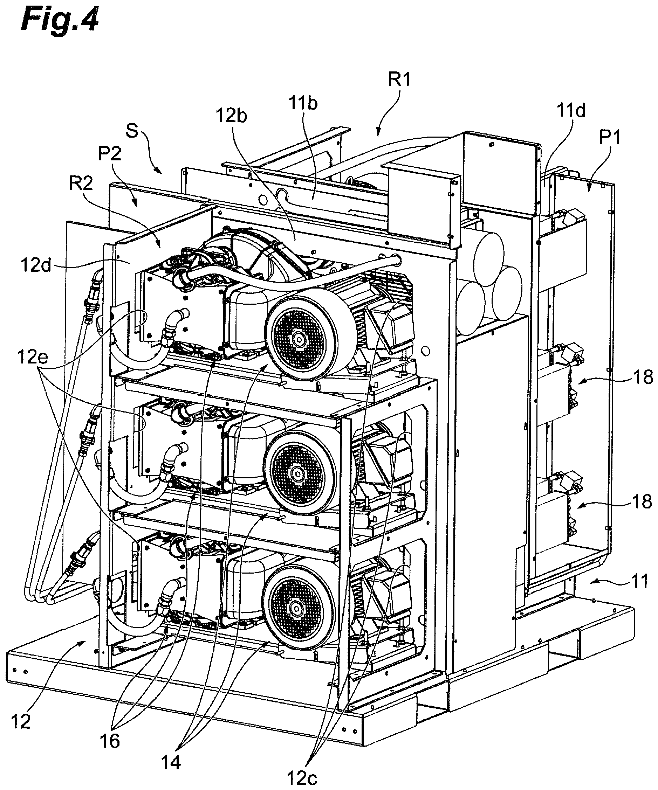

As illustrated in FIG. 4, on the central space S side of the rack 11a of the stacking unit 11, a rectangular partition wall 11b is provided to cover the entire inner side surfaces of the installation region R1. Similarly, on the central space S side of the rack 12a of the stacking unit 12, a rectangular partition wall 12b is provided to cover the entire inner side surface of the installation region R2. On the partition wall 11b and the partition wall 12b, introduction ports 11c and 12c of the cooling air are provided at positions facing the motor 14 of the compressor unit 3. The intake port 10 communicates with the installation region R1 of the stacking unit 11 and the installation region R2 of the stacking unit 12 via the introduction ports 11c and 12c and the central space S.

A rectangular partition wall 11d is provided on the front plate 5 side of the rack 11 a of the stacking unit 11 to cover the front surface of the installation region R1. Similarly, a rectangular partition wall 12d is provided on the rear plate 7 side of the rack 12a of the stacking unit 12 to cover the rear surface of the installation region R2. The discharge ports 11e and 12e of air are provided on the partition wall 11d and the partition wall 12d at positions facing the compressor main body 16 of the compressor unit 3. The discharge ports 11e and 12e are openings for discharging air which has become high-temperature by heat exchange with the compressor main body 16.

As illustrated in FIG. 3, a sirocco fan 16b is provided in the compressor main body 16 of each compressor unit 3. The sirocco fan 16b further sucks the air introduced into the installation regions R1 and R2 toward the compressor main body 16 side, and performs heat exchange between the compressor main body 16 and air. The high-temperature air sucked by the sirocco fan 16b is discharged through the discharge ports 11e and 12e.

Between the partition wall 11d and the front plate 5, a high-temperature exhaust path P1 extending in the up-down direction is provided. Between the partition wall 12d and the rear plate 7, a high-temperature exhaust path P2 extending in the up-down direction is provided. An after-cooler 18 is installed at each position adjacent to the discharge ports 11e and 12e, and the after-coolers 18 are disposed inside the high-temperature exhaust paths P1 and P2. The high-temperature exhaust paths P1 and P2 correspond to a first exhaust path through which the high-temperature air passed through the compressor main body 16 of the plurality of compressor units 3 flows.

As illustrated in FIG 1 and FIG. 2, an upper partition wall 11f extending along the horizontal plane is provided on the upper surface of the stacking unit 11 to close the upper surface of the installation region R1. An upper partition wall 12f extending along the horizontal plane is provided on the upper surface of the stacking unit 12 to close the upper surface of the installation region R2. The upper partition wall 11f and the upper partition wall 12f are disposed on the same plane as the partition wall 13 of the upper portion of the central space S (see FIG. 6). A plurality of circular openings 19 is formed on the upper partition walls 11f and 12f at positions corresponding to the uppermost motor 14 (that is, right above the motor 14), and the exhaust fan is fixed to the openings 19. In this way, the installation regions R1 and R2 correspond to the second exhaust path through which relatively low-temperature air passed through the motors 14 of the plurality of compressor units 3 flows.

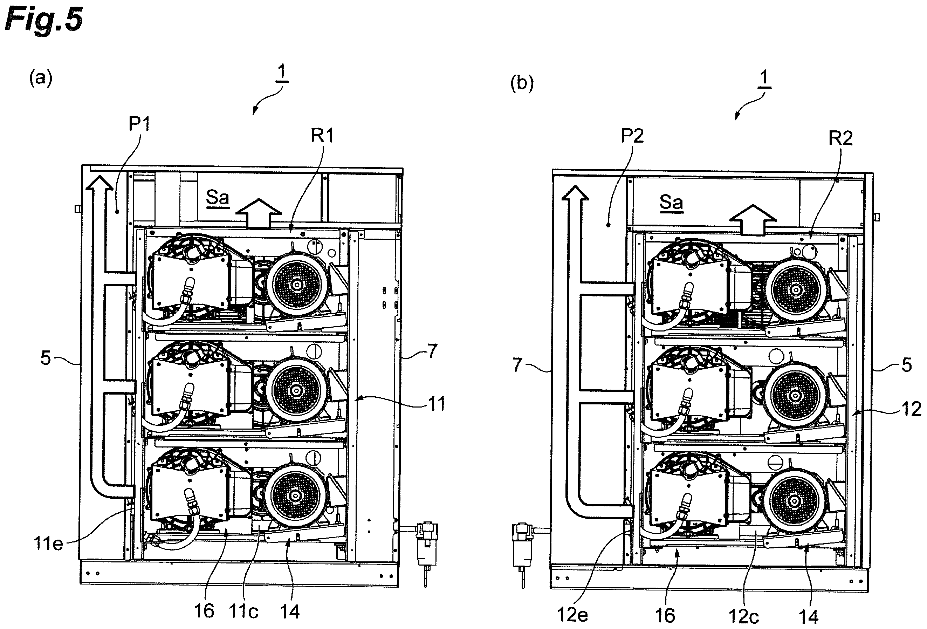

As illustrated in FIG. 5, the high-temperature exhaust paths P1 and P2 serving as the first exhaust path, and the installation regions R1 and R2 serving as the second exhaust path are partitioned by partition walls 11d and 12d, and are different air paths. Both the high-temperature exhaust paths P1 and P2 and the installation regions R1 and R2 extend in the up-down direction, and their extending directions are parallel to each other.

As illustrated in FIGS. 5 and 6, the space of the upper end portion of the high-temperature exhaust paths P1 and P2 (downstream end portion), and the space of the upper end portion of the installation regions R1 and R2 (downstream end portion) communicate with each other. The communicating space Sa is a flat rectangular parallelepiped space formed by the upper end portion of the front plate 5, the upper end portions of the pair of side plates 6, the upper end portion of the rear plate 7, and the top plate 8.

Further, as illustrated in FIGS. 1 and 2, the top plate 8 is provided with one exhaust port 20 for collecting and discharging the air circulated through the plurality of exhaust paths. The exhaust port 20 is the only exhaust opening provided on the top plate 8. The exhaust port 20 is provided in the rear portion of the central portion 8a extending in the front-rear direction, and the rear portions of the side portion 8b and the side portion 8c adjacent to the central portion 8a. The central portion 8a is located above the central space S, the side portion 8b is located above the installation region R1, and the side portion 8c is located above the installation region R2. The exhaust port 20 communicates with the upper end portions of the high-temperature exhaust paths P1 and P2 and the upper end portions of the installation regions R1 and R2. More specifically, the exhaust port 20 is provided above the intermediate position between the stacking unit 11 and the stacking unit 12 (that is, above the central space S) in the top plate 8. Further, the exhaust port 20 is provided on the top plate 8 near the rear plate 7 provided with the intake port 10. The region (area) in the top plate 8 provided with the exhaust port 20 is, for example, half or less of the entire top plate 8.

According to the package type fluid machine 1 of the present embodiment described above, the cooling air flowing into the housing 2 from the intake port 10 passes through the compressor main body 16 of the plurality of compressor units 3 and circulates through the high-temperature exhaust paths P1 and P2. The other part of the air circulates through the installation regions R1 and R2 different from the high-temperature exhaust paths P1 and P2. Further, the air circulated through the high-temperature exhaust paths P1 and P2 and the installation regions R1 and R2 is collected and discharged to the outside of the housing 2 from the single exhaust port 20. In this way, since the exhaust ports 20 are collectively provided, exhaust ports are not scattered. Therefore, for example, even when a package type fluid machine 1 is installed in a room and a duct is provided in the vicinity of the exhaust port 20, the duct can be reduced in size. Further, since sound generated by the compressor main body 16 or the like is suppressed from leaking from the exhaust port 20, it is possible to reduce noise.

Moreover, in the package type fluid machine 1, since the exhaust port 20 is collectively provided on the top plate 8, it is possible to reduce the size of the duct which can be provided in the vicinity of the top plate 8.

Since the exhaust port 20 provided on the top plate 8 is provided above the intermediate position between the stacking unit 11 and the stacking unit 12, the distance from the installation region R1 to the exhaust port 20 and the distance from the installation region R2 to the exhaust port 20 can be substantially equal to each other. Therefore, air from the stacking unit 11 and air from the stacking unit 12 can be discharged from the exhaust port 20 in a well-balanced manner.

In addition, since a single intake port 10 communicating with a plurality of exhaust paths is provided behind the intermediate position between the stacking unit 11 and the stacking unit 12, not only the exhaust port 20 but also the intake port 10 are collectively provided. Therefore, it is possible to further reduce the noise. Further, since the intermediate region between the stacking unit 11 and the stacking unit 12 can be set as an inflow path of the cooling air (that is, the central space S), the space can be effectively utilized.

Although the embodiment of the present invention has been described above, the present invention is not limited to the above embodiment. For example, the position of the exhaust port 20 may not be provided above the intermediate position between the first stacking unit 11 and the second stacking unit 12. The exhaust port 20 may be disposed to be shifted to either the left or the right in the top plate 8. The position of the intake port 10 may not be provided behind the intermediate position between the first stacking unit 11 and the second stacking unit 12. A plurality of intake ports 10 may be provided.

The present invention is not limited to an aspect in which the first stacking unit 11 is provided in the installation region R1 and the second stacking unit 12 is provided in the installation region R2. An aspect in which only one stacking unit is included in the housing 2 may be provided. The exhaust port 20 may not be provided on the top plate 8. An aspect in which the exhaust port 20 is provided on, for example, the side plate 6 or the like may be provided. A separate flow path different from the installation regions R1 and R2 may be provided as the second path.

### Industrial Applicability

According to some aspects of the present invention, it is possible to reduce the size of the duct that can be attached for exhaust and furthermore, it is possible to reduce noise.

### Reference Signs List

1 ... Package type fluid machine, 2 ... Housing, 3 ... Compressor unit (fluid machine unit), 5 ... Front plate (side plate portion), 6 ... Side plate (side plate portion), 7 ... Rear plate (side plate portion), 8 ... Top plate (top plate portion), 10 ... Intake port, 11 ... First stacking unit, 12 ... Second stacking unit, 16 ... Compressor main body (fluid machine), 20 ... Exhaust port, P1, P2 ... High-temperature exhaust path (first exhaust path), R1, R2 ... Installation region (second exhaust path).

## Claims

1. A package type fluid machine including a plurality of fluid machine units installed in a housing, the machine comprising:
at least one intake port which is provided in the housing and communicates with an installation region of the plurality of fluid machine units to allow a cooling gas to flow therein;
a plurality of exhaust paths which is provided inside the housing, and includes a first exhaust path which allows the gas passed through the fluid machine of the plurality of fluid machine units to flow, and a second exhaust path different from the first exhaust path; and
a single exhaust port which is provided in the housing, communicates with downstream end portions of the plurality of exhaust paths, and collects and discharges the gas flowed through the plurality of exhaust paths.

2. The package type fluid machine according to claim 1, wherein the housing has a plurality of side plate portions and a single top plate portion, and the exhaust port is provided in the top plate portion.

3. The package type fluid machine according to claim 2, further comprising:
a first stacking unit and a second stacking unit in which the fluid machine units are stacked in each of a first installation region and a second installation region respectively, the first installation region and the second installation region being adjacent to each other in a horizontal direction within the housing,
wherein the top plate portion covers the first stacking unit and the second stacking unit from above, and
the exhaust port of the top plate portion is provided above an intermediate position between the first stacking unit and the second stacking unit.
